# EUROPEAN PATENT APPLICATION

(11) **EP 4 239 668 A1**
(43) Date of publication of application: **06.09.2023**
(21) Application number: 21886247.2
(22) Date of filing: 27.10.2021
(51) Int. Cl.: H01L 23/13, H01L 23/12, H05K 1/09, H05K 3/18, H05K 3/42

(54) **WIRING BOARD, ELECTRONIC DEVICE, AND ELECTRONIC MODULE**

(30) Priority: 30.10.2020 JP 2020182532
(71) Applicant: Kyocera Corporation, Kyoto-shi Kyoto 612-8501 (JP)
(72) Inventor: TAKESHIMA, Yuki, Kyoto-shi, Kyoto 612-8501 (JP); HOSOI, Yoshihiro, Kyoto-shi, Kyoto 612-8501 (JP); KAMASE, Yuji, Kyoto-shi, Kyoto 612-8501 (JP); YAMASHITA, Kyohei, Kyoto-shi, Kyoto 612-8501 (JP)
(74) Representative: Viering, Jentschura & Partner mbB Patent- und Rechtsanwälte
(86) International application number: PCT/JP2021/039572
(87) International publication number: WO 2022/092129

(57) **Abstract**

A wiring board includes an insulation substrate, a through-conductor, and a wiring conductor. The insulation substrate includes a first surface, a second surface opposite to the first surface, and a through-hole extending from the first surface to the second surface. The through-conductor is located in the through-hole and on an opening of the through-hole on a first surface side. The wiring conductor is located on the first surface and connected to the through-conductor. The through-conductor and the wiring conductor contain copper as a main component. The average size of Cu crystal grains in the through-conductor is larger than the average size of Cu crystal grains in the wiring conductor.

## Description

### TECHNICAL FIELD

The present disclosure relates to a wiring board, an electronic device, and an electronic module.

### BACKGROUND OF INVENTION

Electromigration is a phenomena in which the movement of conductor atoms induced by current application causes vacancies in conductors of wiring boards. International Publication No. 2008/084867 describes a semiconductor device having a wiring board including wiring that includes a seed layer, a noble metal liner layer, and a copper wiring film and thus having an improved electromigration resistance.

### SUMMARY

### SOLUTION TO PROBLEM

In the present disclosure, a wiring board includes an insulation substrate, a through-conductor, and a wiring conductor. The insulation substrate includes a first surface, a second surface opposite to the first surface, and a through-hole extending from the first surface to the second surface. The through-conductor is located in the through-hole and on an opening of the through-hole on a first surface side. The wiring conductor is located on the first surface and connected to the through-conductor. The through-conductor and the wiring conductor contain copper as a main component. An average size of Cu crystal grains in the through-conductor is larger than an average size of Cu crystal grains in the wiring conductor.

In the present disclosure, an electronic device includes the wiring board and an electronic component mounted on the wiring board.

In the present disclosure, an electronic module includes the electronic device and a module substrate on which the electronic device is mounted.

### BRIEF DESCRIPTION OF THE DRAWINGS

FIG. 1 is a perspective view of a wiring board according to an embodiment of the present disclosure.
FIG. 2 is a sectional view of a main part of the wiring board of FIG. 1.
FIG. 3 is a view for describing the method for measuring the size of Cu crystal grains.
FIG. 4A is a sectional view of a main part of the wiring board.
FIG. 4B is a plan view of a main part of the wiring board.
FIG. 5 is a view for describing an example method for producing the wiring board according to the embodiment.
FIG. 6 illustrates an electronic device and an electronic module according to embodiments of the present disclosure.

### DESCRIPTION OF EMBODIMENTS

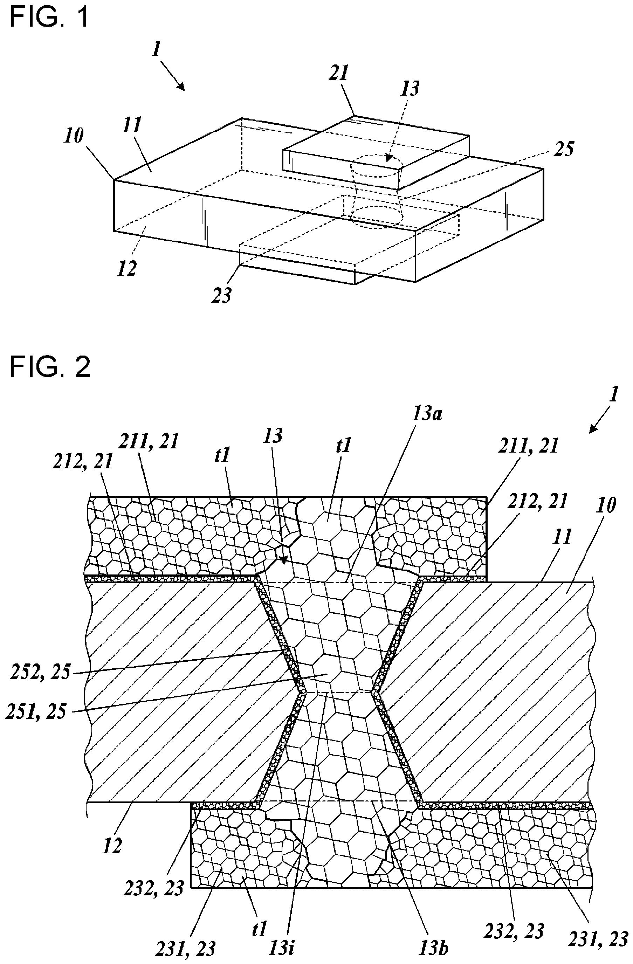

Embodiments of the present disclosure are specifically described below with reference to the drawings. FIG. 1 is a perspective view of a wiring board according to an embodiment of the present disclosure. FIG. 2 is a sectional view of a main part of the wiring board of FIG. 1. FIG. 2 illustrates the cross-section of a through-conductor 25 and the surrounding area in a wiring board 1.

In an embodiment, the wiring board 1 includes an insulation substrate 10, a wiring conductor 21, a through-conductor 25, and a wiring conductor 23. The insulation substrate 10 includes a first surface 11, a second surface 12 opposite to the first surface 11, and a through-hole 13 extending from the first surface 11 to the second surface 12. The wiring conductor 21 is located on the first surface 11. The through-conductor 25 is located in the through-hole 13 and on an opening 13a of the through-hole 13. The wiring conductor 23 is located on the second surface 12. The through-conductor 25 is also located on an opening 13b on the second surface 12 side (on the opposite side across the through-hole 13). The through-conductor 25 is connected to the wiring conductors 21 and 23.

The insulation substrate 10 may be made of a ceramic containing aluminum nitride, silicon nitride, silicon carbide, alumina, zirconia, or the like as a main component.

As indicated by the dashed lines in FIG. 2, the through-hole 13 has the opening 13a on the first surface 11 side and the opening 13b on the second surface 12 side. Since the through-hole 13 and the openings 13a and 13b are filled with the through-conductor 25, the through-hole 13 and the openings 13a and 13b are not empty. The inner diameter of each of the openings 13a and 13b is larger than the inner diameter of a middle part 13i of the through-hole 13. The middle part 13i is a flat part of the through-hole 13 parallel to the first surface 11 between the opening 13a and the opening 13b. The inner diameter of the through-hole 13 may gradually increase from the middle part 13i to the opening 13a on the first surface 11 side. Similarly, the inner diameter of the through-hole 13 may gradually increase from the middle part 13i to the opening 13b on the second surface 12 side. This configuration enables easy control of the Cu crystal grains t1 of the through-conductor 25 with which the through-hole 13 is filled in the stage of producing the wiring board 1.

The through-hole 13 does not necessarily have a circular cross-section (cross-section parallel to the first surface 11). If the cross-section is other than circular, the "inner diameter" is read as a "maximum width".

The wiring conductor 21 includes a main conductor part 211 containing Cu (copper) as a main component, and a middle layer 212 located between the main conductor part 211 and the first surface 11. The through-conductor 25 includes a main conductor part 251 containing Cu as a main component, and a middle layer 252 located between the main conductor part 251 and the inner circumferential surface of the through-hole 13. The wiring conductor 23 includes a main conductor part 231 containing Cu as a main component, and a middle layer 232 located between the main conductor part 231 and the second surface 12. The middle layers 212, 232, and 252 contain Cu, Ti (titanium), and O (oxygen). The main component refers to a component contained in an amount of 80 mass% or more.

The main conductor parts 211 and 231 of the wiring conductors 21 and 23 and the main conductor part 251 of the through-conductor 25 are made of a polycrystalline metal composed of multiple Cu crystal grains t1. In FIGs. 2, 3, 4A, and 4B, the Cu crystal grains t1 are schematically illustrated. Actual Cu crystal grains t1 have various shapes, such as granular or columnar shapes, and vary in size.

The middle layers 212 and 232 of the wiring conductors 21 and 23 and the middle layer 252 of the through-conductor 25 are made of a polycrystalline metal composed of multiple Cu crystal grains and multiple titanium oxide crystal grains.

### <Size of Cu Crystal Grains>

The sizes of the Cu crystal grains t1 of the wiring conductors 21 and 23 and the Cu crystal grains t1 of the through-conductor 25, and the Cu crystal grains of the middle layers 212, 232, and 252 are described. Hereinafter, the Cu crystal grains t1 of the wiring conductors 21 and 23 and the Cu crystal grains t1 of the through-conductor 25 refer to the Cu crystal grains t1 of the main conductor parts 211, 231, and 251. The sizes of the Cu crystal grains are expressed in a unit of length.

The wiring conductor 21 is distinguished from the through-conductor 25 by the average size of the Cu crystal grains t1. The average size of the Cu crystal grains t1 of the through-conductor 25 is larger than the average size of the Cu crystal grains t1 of the wiring conductor 21. A difference between the average sizes of the Cu crystal grains t1 is a difference exceeding the error. The difference exceeding the error may denote a difference of 1.5 times or more or 2 times or more of the standard deviation σ of the size of the Cu crystal grains t1 measured in any area.

Electromigration tends to occur near the opening 13a of the through-hole 13 at which the current direction changes and the current concentrates in charge flow from the wiring conductor 21 to the through-conductor 25. When the average size of the Cu crystal grains t1 of the through-conductor 25 is larger than the average size of the Cu crystal grains t1 of the wiring conductor 21, the Cu crystal grains t1 are difficult to move in the through-conductor 25, which can improve electromigration resistance near the opening 13a of the through-hole 13.

A difference between the average size of the Cu crystal grains t1 of the through-conductor 25 and the average size of the Cu crystal grains t1 of the wiring conductor 21 is 3 µm or less. With this configuration, a small difference in the size of the Cu crystal grains t1 across the boundaries between the wiring conductor 21 and the through-conductor 25 can also improve electromigration resistance at the boundaries.

The configuration on the first surface 11 side is described above. The configuration on the second surface 12 side may be the same as and/or similar to the configuration on the first surface 11 side. In other words, the average size of the Cu crystal grains t1 of the through-conductor 25 may be larger than the average size of the Cu crystal grains t1 of the wiring conductor 23 on the second surface 12 side. A difference between the average sizes of the Cu crystal grains t1 may be a difference exceeding the error and may be 3 µm or less. This configuration can also improve, on the second surface 12 side, the resistance to the electromigration, which tends to occur near the opening 13b in charge flow from the wiring conductor 23 to the through-conductor 25.

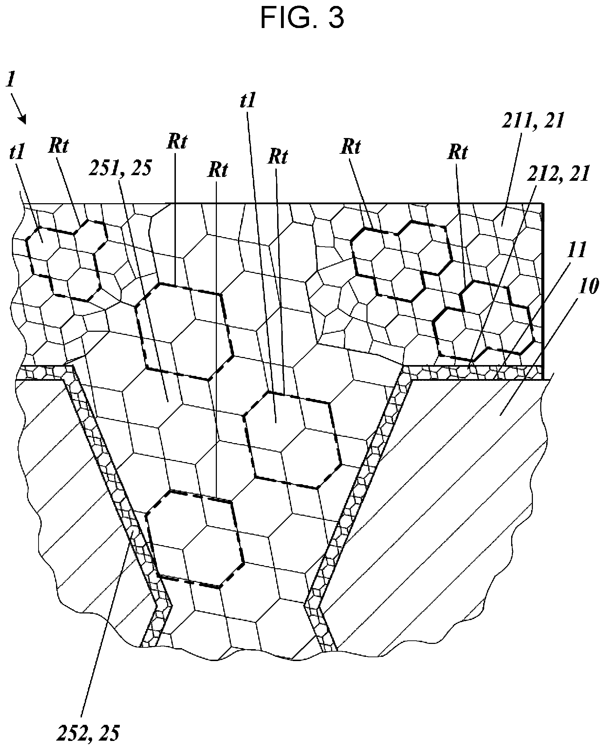

Since the Cu crystal grains t1 have various shapes, such as granular or columnar shapes, the average size of the Cu crystal grains t1 is determined in the following steps 1 to 3. FIG. 3 is a view for describing the method for measuring the size of the Cu crystal grains. In FIG. 3, the Cu crystal grains t1 are simplified, and the number of the Cu crystal grains t1 in target regions Rt differs from the actual number.
1. The lines of the boundaries (grain boundaries) between the Cu crystal grains t1 in the SEM (scanning electron microscope) image or the SIM (scanning ion microscope) image of the cross-section including the through-conductor 25 and the wiring conductor 21 are extracted.
2. From the image, regions having sizes including 20 to 100 Cu crystal grains t1 are randomly selected as the target regions Rt. Multiple target regions Rt are selected from a main part of a target conductor (the main conductor part 251 of the through-conductor 25, the main conductor parts 211 and 231 of the wiring conductors 21 and 23).
3. The number of the Cu crystal grains t1 in each target region Rt is counted, and the area of each target region Rt is divided by the corresponding number of the Cu crystal grains t1 to obtain the average cross-sectional area of the individual Cu crystal grains t1. Assuming that each Cu crystal grain t1 has a circular cross-section, the diameter of the circle is calculated from the area, and the diameter is obtained as the average size of the Cu crystal grains t1.

### <Example>

The average sizes of the Cu crystal grains t1 of the through-conductor 25 and the wiring conductor 21 in the wiring board 1 according to Example of the present disclosure were measured, and the results in the measurement result 1 were obtained.

**[Table 1]**

| [Measurement Result 1] | | |
|---|---|---|
| | Average Size of Cu Crystal Grains [µm] | |
| Target Region No. | Wiring Conductor | Through-Conductor |
| 1 | 3.41 | 4.36 |
| 2 | 4.00 | 4.62 |
| 3 | 4.10 | 5.32 |

The results indicate that the average size of the Cu crystal grains t1 of the through-conductor 25 is larger than the average size of the Cu crystal grains t1 of the wiring conductor 21, and a difference between the average sizes of the Cu crystal grains t1 is 3 µm or less.

### <Boundary Between Wiring Conductor and Through-Conductor>

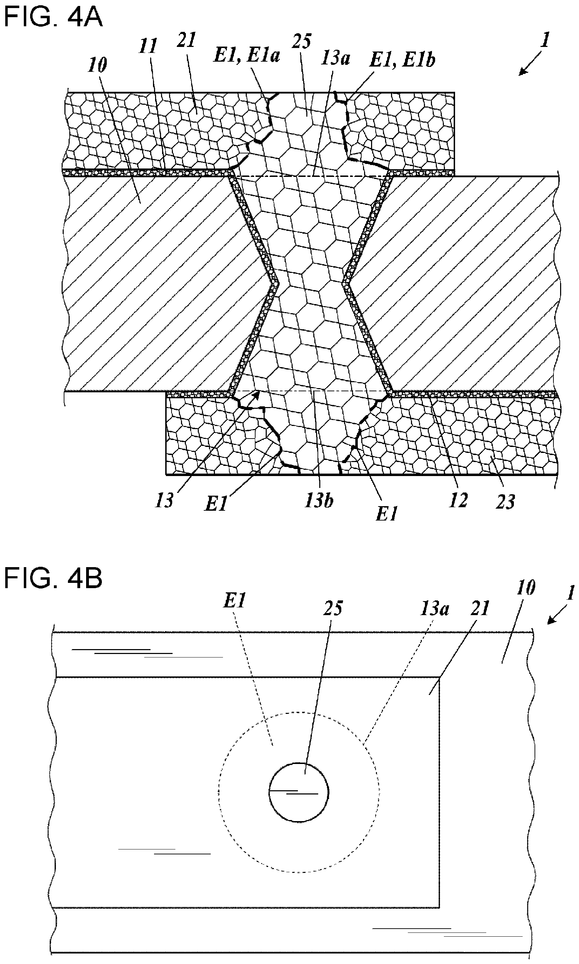

FIG. 4A and FIG. 4B are views for describing the boundaries between the wiring conductor and the through-conductor. FIG. 4A is a sectional view of a main part of the wiring board, and FIG. 4B is a plan view of the main part. The cross-section of FIG. 4A passes through the through-hole 13 and is perpendicular to the first surface 11.

Many target regions Rt are set near the opening 13a of the through-hole 13, and the average size of the Cu crystal grains t1 in each target region Rt is measured. The boundary lines (indicated by the dashed lines in FIG. 4A) across which the average size changes stepwise are extracted to specify the boundary lines as the boundaries E1 between the through-conductor 25 and the wiring conductor 21.

In the cross-section of FIG. 4A, the boundaries E1 may be located outside the through-hole 13 (i.e., outside the opening 13a of the through-hole 13). All of the boundaries E1 may be located outside the through-hole 13. Electromigration tends to occur near the opening 13a of the through-hole 13 at which the current direction changes and the current concentrates in charge flow from the wiring conductor 21 to the through-conductor 25. With the boundaries E1 having such a configuration, however, the Cu crystal grains t1 of the through-conductor 25 occupy the inside and the outside of the opening 13a, and thus a difference is small in the size of the Cu crystal grains t1 between the inside and the outside of the opening 13a. This configuration can improve electromigration resistance near the opening 13a of the through-hole 13.

The boundaries E1 have the same and/or similar tendency regardless of the orientation of the cross-section (the orientation in the direction of rotation about the central axis of the through-hole 13). Therefore, as the wiring board 1 is viewed in the direction perpendicular to the first surface 11, the boundary E1 has an area overlapping the opening 13a of the through-hole 13 of the insulation substrate 10 as illustrated in FIG. 4B. In the range having the overlap described above, a difference is small in the size of the Cu crystal grains t1 between the inside and the outside of the opening 13a. This configuration can thus improve the electromigration resistance near the opening 13a of the through-hole 13. The boundary E1 may overlap the opening 13a in the entire area of the opening 13a of the through-hole 13 in the circumferential direction. This configuration can improve the electromigration resistance in the entire area of the opening 13a of the through-hole 13 in the circumferential direction.

In the cross-section of FIG. 4A, the boundaries E1 include a first boundary line E1a on the left side and a second boundary line E1b on the right side, and the distance between the first boundary line E1a and the second boundary line E1b may decrease with an increase of distance from the through-hole 13 (opening 13a). The width of the through-conductor 25 may decrease with an increase of distance from the through-hole 13 (opening 13a). This configuration can reduce a difference in the size of the Cu crystal grains t1 in an area where the current direction changes and the current concentrates in charge flow from the wiring conductor 21 to the through-conductor 25. This area can thus have improved electromigration resistance. In the cross-section described above, the angle between each of parts of the boundary E1 and the line segment indicating the opening 13a may decrease with proximity to the edge of the opening 13a. This configuration can reduce a difference in the size of the Cu crystal grains t1 in an area where the charge direction changes and the charge flow concentrates. This area can thus have improved electromigration resistance.

The configuration on the first surface 11 side is described above. The configuration on the second surface 12 side may be the same as and/or similar to the configuration on the first surface 11 side. In other words, the relationship of the boundary E1 between the wiring conductor 23 and the through-conductor 25 with the opening 13b on the second surface 12 side may be the same as, and/or similar to, the relationship between the boundary E1 and the opening 13a on the first surface 11 side. This configuration can reduce a difference in the size of the Cu crystal grains t1 in an area where the charge direction changes and the charge flow concentrates in charge flow from the wiring conductor 23 to the through-conductor 25. This area can thus have improved electromigration resistance.

### <Middle Layer>

The middle layers 212, 232, and 252 contain at least Cu, Ti, and O, and are made of a polycrystalline metal composed of multiple Cu crystal grains and multiple titanium oxide crystal grains, as described above. In comparison between the middle layer 252 of the through-conductor 25 and the main conductor part 251 of the through-conductor 25, the Cu crystal grains in the main conductor part 251 have a larger average size than the Cu crystal grains in the middle layer 252. In comparison between the middle layers 212 and 232 of the wiring conductors 21 and 23 and the main conductor parts 211 and 231 of the wiring conductors 21 and 23, the Cu crystal grains in the main conductor parts 211 and 231 have a larger average size than the Cu crystal grains in the middle layers 212 and 232.

The components and the average size of the Cu crystal grains in the middle layers 212 and 232 of the wiring conductors 21 and 23 may be substantially the same as those in the middle layer 252 of the through-conductor 25.

Even if thermal stress is generated between the insulation substrate 10 and the wiring conductors 21 and 23 and between the insulation substrate 10 and the through-conductor 25, the presence of the middle layers 212, 232, and 252 reduces the concentration of thermal stress and can improve the TCT (temperature cycle testing) resistance of the wiring board 1.

### <Production Method>

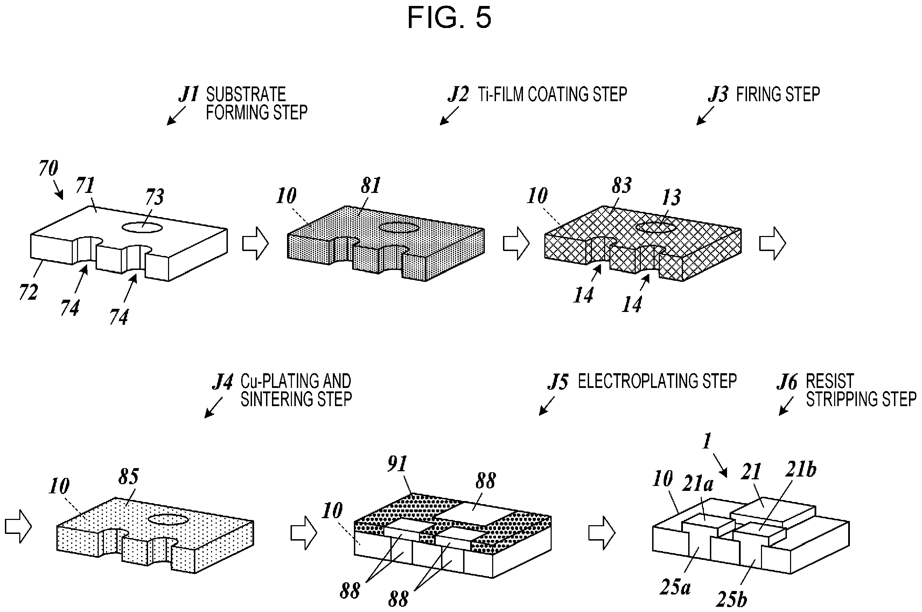

FIG. 5 is a view for describing an example method for producing the wiring board according to the embodiment.

In this embodiment, the production method includes in order, a substrate forming step J1 for forming the insulation substrate 10, a Ti-film coating step J2, a firing step J3, a Cu-plating and sintering step J4, an electroplating step J5, and a resist stripping step J6.

In the substrate forming step 11, a ceramic green sheet, which is a ceramic before sintering, is processed into a substrate shape by punching, die-cutting, or other techniques to form a substrate 70 before firing. The substrate 70 is provided with a through-hole 73 and side grooves 74. The through-hole 73 and the side grooves 74 extend from a first surface 71 to a second surface 72 opposite to the first surface 71. The through-hole 73 is formed such that the diameter of the through-hole 73 at a midpoint of the depth (the height between the first surface 71 and the second surface 72) is smaller than the diameter of the opening of the first surface 71 and the diameter of the opening of the second surface 72. Subsequently, the substrate 70 is fired so that the substrate 70 is converted into the insulation substrate 10, which is a ceramic, and the through-hole 73 and the side grooves 74 of the substrate 70 before firing are converted into the through-hole 13 and side grooves 14 respectively having shapes same as, and/or similar to, those of the through-hole 73 and the side grooves 74. Note that, the through-hole 13 and the side grooves 14 may be formed by using a technique, such as laser or blasting, after firing the ceramic green sheet.

In the Ti-film coating step J2, an organic Ti-liquid 81 is applied to the fired insulation substrate 10. The organic Ti-liquid 81 is also applied to the inner surfaces of the through-hole 73 and the side grooves 74. The organic Ti-liquid 81 may be applied in the same thickness to the first surface 71, the second surface 72, the inner surface of the through-hole 73, and the inner surfaces of the side grooves 74.

In the firing step J3, the organic Ti-liquid 81 applied to the insulation substrate 10 is fired so that the applied organic Ti-liquid 81 is converted into a Ti oxide film 83.

In the Cu-plating and sintering step J4, non-electrolytic Cu plating is first performed on the Ti oxide film 83 on the surface of the insulation substrate 10, and sintering is next performed to diffuse elements present at the interface between the Ti oxide film 83 and the Cu-plated film. The sintering causes diffusion of Cu in the Ti oxide film 83 to form a seed layer 85. The seed layer 85 corresponds to the middle layers 212, 232, and 252 in the wiring board 1 after the production process.

In the electroplating step J5, a resist pattern 91 is formed so as to expose the areas of the wiring conductor 21 and 23 and the through-conductors 25, and electrolytic Cu plating is performed on regions of the seed layer 85 not covered by the resist pattern 91. The electrolytic Cu plating forms Cu-deposited conductors 88 on the seed layer 85 and causes the through-hole 13 and the side grooves 14 to be filled with the Cu-deposited conductors 88. The Cu-deposited conductors 88 correspond to the main conductor parts 211 and 231 of the wiring conductors 21 and 23 and the main conductor part 251 of the through-conductor 25. The electrolytic Cu plating can be performed by using a through-hole/via filling coating liquid containing copper sulfate (e.g., VF-II available from JCU Corporation). The substrate is placed on a conductive rack, and the substrate is subjected to degreasing, acid pickling, and other treatments. The substrate is then immersed in the coating liquid, and the Cu-deposited conductors 88 are formed by application of a current of about 0.5 to 3.0 A/dm².

In the resist stripping step J6, the resist pattern 91 is stripped, and the regions of the seed layer 85 not covered by the Cu-deposited conductors 88 are etched away to produce the wiring board 1. The production method described above can produce the wiring board 1 in which the wiring conductors 21 and 23 differ from the through-conductor 25 in the average size of the Cu crystal grains t1 as described above. In the wiring board 1 of FIG. 5, the structure of FIG. 1 further includes wiring conductors 21a and 21b and castellations 25a and 25b.

### <Electronic Device and Electronic Module>

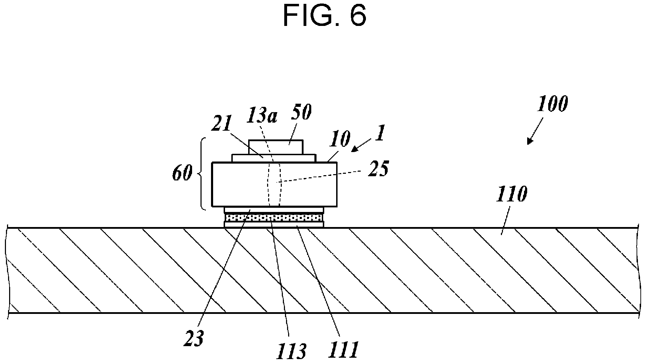

FIG. 6 is a sectional view illustrating an electronic device and an electronic module according to embodiments of the present disclosure.

In an embodiment, an electronic device 60 includes an electronic component 50 mounted on a wiring board 1. A terminal of the electronic component 50 may be connected to the wiring conductor 21, and the terminal may be electrically connected to the wiring conductor 23 on the second surface 12 side through the wiring conductor 21 and the through-conductor 25. The wiring conductors 21 and 23 may have a Ni-film on their surfaces.

The electronic component 50 may be selected from optical elements, such as LDs (laser diodes), PDs (photo diodes), LEDs (light emitting diodes); image sensors, such as CCD (charge coupled device) image sensors, and CMOS (complementary metal oxide semiconductor) image sensors; piezoelectric oscillators, such as crystal oscillators; semiconductor devices, such as surface acoustic wave devices, and semiconductor integrated circuit devices (IC: integrated circuit); and various electronic components, such as capacitors, inductors, and resistors.

In an embodiment, an electronic module 100 includes the electronic device 60 mounted on a module substrate 110. In addition to the electronic device 60, other electronic devices, electronic elements, electric elements, and the like may be mounted on the module substrate 110. The module substrate 110 may be provided with an electrode pad 111, and the wiring conductor 23 of the electronic device 60 may be bonded to the electrode pad 111 with a bonding material 113, such as a solder.

According to the electronic device 60 and the electronic module 100 of the embodiments, the wiring board 1 with improved electromigration resistance near the opening 13a can improve the reliability of the electronic device 60 and the electronic module 100.

The embodiments of the present disclosure are described above. However, the wiring board, the electronic device, and the electronic module of the present disclosure are not limited to those according to the embodiments. For example, in the embodiments, the wiring conductors are exposed on the outer surfaces of the wiring board, and the through-conductor is located between the two wiring conductors exposed on the outer surfaces of the wiring board. However, the wiring conductors may be located in a substrate of a multilayer wiring board, and the through-conductor may be an interlayer via of the multilayer wiring board. The through-conductor may be a conductor constituting a through-hole or may be a conductor constituting castellations.

### INDUSTRIAL APPLICABILITY

The present disclosure can apply to wiring boards, electronic devices, and electronic modules.

### REFERENCE SIGNS

1 wiring board
10 insulation substrate
11 first surface
12 second surface
13 through-hole
13a, 13b opening
13i middle part
21, 23 wiring conductor
25 through-conductor
211, 231, 251 main conductor part
212, 232, 252 middle layer
t1 Cu crystal grains
E1 boundary
E1a first boundary line
E1b second boundary line
50 electronic component
60 electronic device
100 electronic module
110 module substrate

## Claims

1. A wiring board comprising:
an insulation substrate comprising:
a first surface;
a second surface opposite to the first surface; and
a through-hole extending from the first surface to the second surface;
a through-conductor located in the through-hole and on an opening of the through-hole on a first surface side; and
a wiring conductor located on the first surface and connected to the through-conductor,
wherein the through-conductor and the wiring conductor contain copper as a main component, and
an average size of Cu crystal grains in the through-conductor is larger than an average size of Cu crystal grains in the wiring conductor.

2. The wiring board according to claim 1,
wherein a difference between the average size of the Cu crystal grains in the through-conductor and the average size of the Cu crystal grains in the wiring conductor is 3 µm or less.

3. The wiring board according to claim 1 or 2,
wherein a boundary between the through-conductor and the wiring conductor is located outside the through-hole.

4. The wiring board according to any one of claims 1 to 3,
wherein a boundary between the through-conductor and the wiring conductor includes an area overlapping the through-conductor as viewed in a direction perpendicular to the first surface.

5. The wiring board according to any one of claims 1 to 4,
wherein, in a cross-section passing through the through-hole and perpendicular to the first surface, a distance between a first boundary line and a second boundary line decreases with an increase of distance from the through-hole, the first boundary line indicating a left boundary between the through-conductor and the wiring conductor, the second boundary line indicating a right boundary between the through-conductor and the wiring conductor.

6. The wiring board according to any one of claims 1 to 5,
wherein, in a cross-section passing through the through-hole and perpendicular to the first surface, an angle between each of parts of a boundary line and a line segment on the cross-section decreases with proximity to an edge of the opening, the boundary line indicating a boundary between the through-conductor and the wiring conductor, the line segment indicating the opening of the through-hole.

7. An electronic device comprising:
the wiring board according to any one of claims 1 to 6; and
an electronic component mounted on the wiring board.

8. An electronic module comprising:
the electronic device according to claim 7; and
a module substrate on which the electronic device is mounted.
